# EUROPÄISCHE PATENTSCHRIFT

(11) **EP 3 062 185 B1**
(45) Veröffentlichungstag und Bekanntmachung des Hinweises auf die Patenterteilung: **22.12.2021**
(21) Anmeldenummer: 16157042.9
(22) Anmeldetag: 24.02.2016
(51) Int. Cl.: G05B 23/02, H02H 7/26, H02J 3/36, G01R 31/08

(54) **MODELBASIERTES SCHUTZSYSTEM FÜR ELEKTRISCHE SYSTEME**
MODEL-BASED PROTECTION SYSTEM FOR ELECTRIC SYSTEMS
SYSTEME DE PROTECTION DE SYSTÈMES ÉLECTRIQUES BASÉ SUR DES MODÈLES CARACTÉRISANT DES PANNES

(30) Priorität: 27.02.2015 DE 102015203570
(43) Veröffentlichungstag der Anmeldung: 31.08.2016
(73) Patentinhaber: Siemens Energy Global GmbH & Co. KG, 81739 München (DE)
(72) Erfinder: Al Hage Ali, Ali, 91080 Spardorf (DE); Buchstaller, Dominic, Dr., 91341 Röttenbach (DE); Engel, Markus, 90469 Nürnberg (DE)

(56) Entgegenhaltungen:
- EP-A2- 1 189 126
- CN-A- 103 217 286
- US-A1- 2013 088 802

## Beschreibung

Die vorliegende Erfindung betrifft ein Verfahren und ein System zur Überwachung und/oder zum Schutz eines Systems, insbesondere zur groben und exakten Lokalisierung sowie Klassifizierung eines Fehlers in dem System, beispielsweise eines Gleichstrom-(DC-) Übertragungsnetzes.

Im Zuge der Energiewende und der stetig wachsenden Anzahl von erneuerbaren Stromerzeugungseinrichtungen sind strukturelle Veränderungen in den Übertragungs- und Verteilnetzen notwendig. Insbesondere die Netzschutztechnik muss sich neuen Herausforderungen stellen, die herkömmlicherweise lediglich teilweise beherrscht sind.

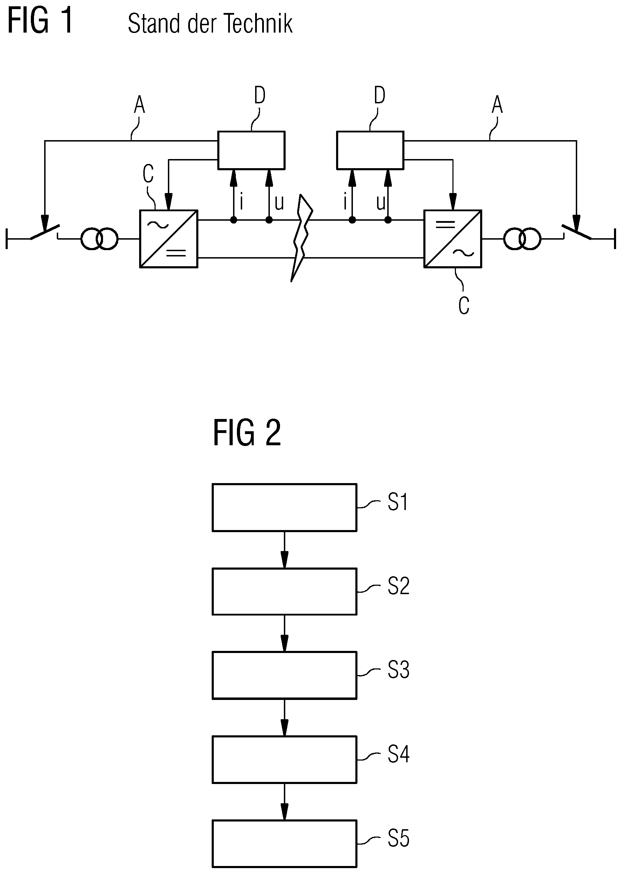

Im Übertragungsbereich sind herkömmlicherweise Hochspannungs-Gleichstrom-Übertragungssysteme (HGÜ) ausschließlich als Punkt-zu-Punkt-Verbindungen aufgebaut, wie es beispielsweise in Figur 1 dargestellt ist. Kommt es zu einem DC-seitigen Fehler, der von einem DC-Leitungsschutz D erfasst wird, wird das gesamte Konverterblöcke C aufweisende System mittels AC-Leistungsschalter A abgeschaltet und erst nach einer Fehlerklärung wieder in Betrieb gesetzt.

Diese herkömmliche Technik kann nicht direkt auf DC-Netzstrukturen übertragen werden, da ein selektives Abschalten von Netzteilen nicht möglich ist.

Das Problem mit herkömmlichen Fehlererkennungsmethoden ist in diesem Kontext, dass entweder die Anforderungen an die Selektivität oder die Anforderungen an die Reaktionsschnelligkeit erfüllt werden, aber nicht beide gleichzeitig. Zudem gibt es oft keine eindeutige Methodik, beispielsweise eine Einstellregel für die Bestimmung der Schutzparameter, wie es beispielsweise Schwellwerte sind, was aufwändige Simulationen für jede Installation erfordert.

Beispielsweise ermöglicht ein herkömmlicher Leitungsdifferentialschutz eine hochselektive Fehlererkennung, jedoch ist dieser aufgrund einer Kommunikationsverzögerung zu langsam, um in ausgedehnten HGÜ-Systemen wirksam arbeiten zu können. Andere herkömmliche lokale Methoden könnten Selektivität gewährleisten, ihnen fehlt aber eine klare Einstellungsleitlinie. Deren Einstellung sowie Kalibrierung basiert lediglich auf offline-Simulationen und Tests.

In AC-Übertragungsnetzen (AC: Alternating Current) sind die Anforderungen an die Reaktionsschnelligkeit weniger kritisch als bei DC-Gleichstromnetzen (DC: Direct Current), da
a) kein Umrichter geschützt werden muss,
b) die Lasttrenneinrichtungen auch unter hohen Fehlerströmen schalten können, nämlich während eines AC-Nulldurchgangs,
c) AC-Kabel typischerweise eine höhere Impedanz aufweisen, so dass der Fehlerstrom geringer ist.

Für AC-Übertragungsnetze existieren bereits Schutzgeräte, die eine wirksame selektive Fehlererkennung ermöglichen, wie beispielsweise der Leitungsdifferentialschutz und Distanzschutz. In Niederspannungs- und Verteilnetzen wird die Schutztechnik weitestgehend durch die Primärtechnik, zum Beispiel in Form von Sicherungen ausgeführt. Das Problem bei den AC-Verteilnetzen besteht darin, dass dort heutzutage nur wenige Messgeräte eingebaut sind, womit ein aktives Schutzsystem schwer zu realisieren ist. Dies wird sich jedoch in Zukunft ändern, da die Kosten für die Realisierung von Messstellen immer weiter sinken.

Neben einer Fehlererkennung ist eine exakte Fehlerlokalisierung und Fehlerklassifizierung wichtig, um Reparaturarbeiten und Wiederinbetriebnahme des fehlerbehafteten Netzteils effektiv planen und durchführen zu können. Besonders die Erkennung und Lokalisierung von Leitungsfehlern ist von großer Bedeutung, da die Leitungen, die beispielsweise Kabel oder Freileitungen sein können, im Allgemeinen hunderte Kilometer lang sind. Auf dem Markt existieren bereits einige Geräte für die exakte Fehlerlokalisierung. Der Einsatz dieser Geräte ist jedoch mit hohen Kosten verbunden.

Herkömmlicherweise ist es noch nicht gelöst, eine robuste und schnelle, innerhalb von wenigen Millisekunden stattfindende, Identifikation eines fehlerbehafteten Netzteils zur groben Lokalisierung des Fehlers bereitzustellen.

In AC-Übertragungsnetzen werden herkömmlicherweise Distanzschutzrelais und/oder Differentialschutzrelais als Hauptschutz verwendet. Beispiele sind hierzu Systeme der Firma Siemens, wie es beispielsweise die SIPROTEC 7SL86 als kombinierter Leistungsdifferential- und Distanzschutz, die SIPROTEC 7SD84 als Leitungsdifferentialschutz und die SIPROTEC 7SA84 als Distanzschutz sind. In Niederspannungsbeziehungsweise Verteilnetzen wird herkömmlicherweise die Schutztechnik weitestgehend durch eine Primärtechnik, beispielsweise in Form von Sicherungen, ausgeführt.

In Punkt-zu-Punkt-HGÜ-Systemen erfolgt die Fehlerklärung herkömmlicherweise unabhängig von dem Fehlererkennungsalgorithmus primär über die AC-seitigen Leistungsschalter beziehungsweise Unterbrecher A, wie sie in Figur 1 dargestellt sind. Diese nicht-selektive Methode ist für DC-Netze daher ungeeignet. In [1] wird der Stromdifferentialschutz als mögliches Verfahren zur Detektion von Leitungsfehlern in vermaschten HGÜ-Netzen vorgeschlagen. Der Nachteil dieser Vorgehensweise besteht in der Notwendigkeit eines parallelen Telekommunikationssystems, womit die Anforderung an die Reaktionszeit aufgrund der Kommunikationsverzögerung nicht erfüllt werden können. Eine schnelle DC-Fehlerdetektion sollte aus diesem Grund telekommunikationslos erfolgen. Dies wird beispielsweise durch die in [2] beschriebene Handshaking-Methode realisiert. Der Nachteil der Handshaking-Methode besteht darin, dass die fehlerbehaftete Leitung erst im Zuge der Fehlerklärung erkannt wird. Da immer eine Beteiligung des gesamten HGÜ-Netzes an der Fehlerklärung erforderlich ist, werden weder die Schnelligkeitsanforderungen noch die Selektivitätsanforderungen erfüllt. Des Weiteren sind Wavelet-Verfahren zur Fehlererkennung in Multi-Terminal DC-Netzen bekannt [3]. Diese Ansätze ermöglichen eine lokale Fehlererkennung ohne Kommunikation, es fehlen jedoch klare Methodiken oder Einstellregeln, um eine korrekte Schutzparametrierung zu bestimmen. Ähnliches gilt für Verfahren, die auf Schwellwerten für Strom und Spannung basieren, sowie deren abgeleitete Größen nutzen, um Fehler zu detektieren, wobei hier beispielsweise auf die in [4] beschriebene Methode hingewiesen wird. Die Bestimmung dieser Schwellwerte basiert lediglich auf Offline-Simulationen und Tests. Wird beispielsweise das Netz um weitere Stationen erweitert, müssten die Einstellparameter erneut berechnet werden.

Herkömmlicherweise sind ein exaktes Lokalisieren und eine Klassifizierung eines Fehlers auf einem fehlerbehafteten Netzteil zwar bereits technisch gelöst, aber es ist die Verwendung von zusätzlichen Spezialgeräten notwendig, was zu sehr hohen Kosten führt. Herkömmlicherweise können für die exakte Lokalisierung und Klassifizierung des Fehlers auf einem fehlerbehafteten Netzteil die Distanzschutzrelais, die in vorstehend beschriebenen AC-Systemen für die Fehlererkennung verwendet werden, dort ebenso zur Bestimmung eines Fehlerortes eingesetzt werden. Die meisten herkömmlichen Techniken für eine exakte Fehlerlokalisierung in einem DC-Netz basieren herkömmlicherweise auf der Betrachtung von Wanderwellenvorgängen. Ein Beispiel hierfür ist ein mit "dcLFL" bezeichnetes Produkt einer Firma Manitoba HVDC Research Centre. Der Nachteil derartiger herkömmlicher Geräte sind hohe Kosten und die Beschränkung auf eine vergleichsweise langsame Offline-Auswertung. Eine Fehlerklassifizierung ist mittels der beiden hier beschriebenen herkömmlichen Geräte ausführbar.

Die CN103217286 A offenbart ein Fehlererkennungsverfahren für eine Windkraftanlage, wobei ein aktuelles Zustandsmodell mit einer Vielzahl von Fehlerzustandsmodellen verglichen wird.

Es ist Aufgabe der vorliegenden Erfindung eine Vorrichtung und ein Verfahren zur groben und exakten Lokalisierung sowie Klassifizierung eines Fehlers in einem System, insbesondere in einem Gleichstrom-(DC)-Energieübertragungssystem derart bereit zu stellen, dass die Fehlererkennung selektiv, wirksam reaktionsschnell und mittels einer eindeutigen Methodik zur Bestimmung von Schutzparametern ausführbar ist.

Die Aufgabe wird mittels eines Verfahrens gemäß dem Hauptanspruch und mittels eines Schutzsystems gemäß dem Nebenanspruch gelöst.

Gemäß einem ersten Aspekt wird ein Verfahren zum Überwachen eines mindestens eine Messstation aufweisenden elektrischen Systems, insbesondere eines elektrischen Energieübertragungssystems, insbesondere eines Hochspannungs-Gleichstrom-Übertragungssystems, mit folgenden Schritten:
Für die jeweilige Messstation mittels Speichereinrichtungen ausgeführtes Abspeichern von einen jeweiligen Zustand des Systems beschreibenden Modellen des Systems in jeweils einer Schätzeinrichtung, die ebenso als ein Estimator bezeichnet werden kann, wobei die Schätzeinrichtungen in einer Schätzeinrichtungsbank, die ebenso als Estimatorbank bezeichnet werden kann, integriert sind; Anwenden der jeweiligen Schätzeinrichtungsbank mittels Vergleichens von von der jeweiligen Messstation gemessenen Werten mit Werten eines jeweiligen Modells; Bestimmen des Modells, in einem idealen Fall eines Modells Pp*, mit dem kleinsten Unterschied, der ebenso als Residuum bezeichnet werden kann, zwischen den aktuell gemessenen Werten und den eigenen modellspezifischen Werten, wobei das bestimmte Modell den aktuellen Zustand des Systems angibt.

Ein Energieübertragungssystem kann ebenso ein Mittel- oder Niederspannungs-Gleichstromsystem sein.

Eine Schätzeinrichtungsbank, die ebenso Estimatorbank bezeichnet werden kann, ist eine Mehrzahl von miteinander, insbesondere logisch, verknüpften Estimatoren. Ein Estimator kann ebenso als ein Schätzer oder eine Schätzeinrichtung bezeichnet werden und ist insbesondere eine Hardware zur Ausführung einer Rechenregel, und zwar hier zur Berechnung einer Übereinstimmung oder eines Unterschieds zwischen einem dynamischen Systemmodell und messtechnisch erfasster Messdaten. Der Hardware können softwaremäßige Bestandteile zur Implementierung, beispielsweise in einer Rechnereinrichtung, zugeordnet sein.

In einem Estimator wird ein Modell abgespeichert.

Ein dynamisches Systemmodell umfasst eine Gesamtheit von unterschiedliche Zustände eines Systems beschreibenden Modellen.

Gemäß der Erfindung wird in Anspruch 26 ein Schutzsystem zur Überwachung eines mindestens eine Messstation aufweisenden elektrischen Systems, insbesondere eines elektrischen Energieübertragungssystems, insbesondere eines Hochspannungs-Gleichstrom-Übertragungssystems, vorgeschlagen. Anspruch 1 offenbart das korrespondierende Verfahren.

Ein elektrisches System weist hier insbesondere elektrische Komponenten oder elektrische Bauelemente auf, die mittels elektrischer Leitungen miteinander verbunden sind, die Energie und/oder Informationen übertragen. Eine besondere Ausführungsform ist hier ein elektrisches Energiesystem oder Energieübertragungssystem oder Energieverteilungssystem, insbesondere ein Hochspannungs-Gleichstrom oder - Wechselstrom-Übertragungssystem.

Es kann vorteilhaft ein alle Zustände des elektrischen Systems beschreibendes analytisches dynamisches Modell in Form einer mathematischen Netzstruktur bereitgestellt werden, die als eine Schätzeinrichtungsbank oder Estimatorbank ausgebildet sein kann.

Eine Schätzeinrichtungsbank kann vorteilhaft als eine entsprechend angepasste Rechnereinrichtung in Kombination mit Speichereinrichtungen geschaffen sein.

Gemäß der vorliegenden Erfindung werden vorteilhaft modellbasierte Netzschätzer oder sogenannte Estimatoren verwendet.

Weitere vorteilhafte Ausgestaltungen werden in Verbindung mit den Unteransprüchen beansprucht.

Es wird für jeden Zustand ein Erzeugen eines mathematischen Modells ausgeführt, wobei jedes Modell jedem Wert mindestens einer Eingangsgröße einem eigenen modellspezifischen Wert mindestens einer Ausgangsgröße zuordnet. Eingangsgröße und Ausgangsgröße können vorteilhafterweise voneinander, insbesondere physikalisch, abhängig sein. Vorteilhafterweise sind damit keine Kalibrierungen eines Fehlererkennungssystems erforderlich und eine Anwendbarkeit ist für beliebige Netz-Topologien des Systems anwendbar. Entsprechend ist keine Kalibrierung eines erfindungsgemäßen Schutzsystems notwendig. Es ergibt sich eine Robustheit gegenüber Störungen und Messrauschen sowie eine Robustheit gegenüber Änderungen in Systemparametern des Systems.

Gemäß einer vorteilhaften Ausgestaltung können zum Erzeugen der mathematischen Modelle des Systems für die mindestens eine Messstation mathematische Beschreibungen von physikalischen Eigenschaften des Systems, insbesondere von Eigenschaften von elektrischen Leitungen im System, verwendet werden.

Gemäß einer vorteilhaften Ausgestaltung kann mittels der mindestens einen Messstation ein Messen von Zuständen im realen System, ausgeführt werden, wobei für jeden Zustand jede Messung jeweils mindestens einen Wert der mindestens einen Eingangsgröße und mindestens einen Wert der mindestens einen Ausgangsgröße misst.

Gemäß der Erfindung wird das Anwenden der jeweiligen Schätzeinrichtungsbank mittels Vergleichens eines aktuell gemessenen Wertes der Ausgangsgröße mit dem jeweiligen eigenen modellspezifischen Wert der Ausgangsgröße eines jeweiligen Modells bei einem von der Messstation aktuell gemessenen und in der Schätzeinrichtungsbank abgespeicherten Wert der Eingangsgröße ausgeführt, wobei ein Bestimmen des Modells mit dem kleinsten Unterschied oder Residuum des aktuell gemessenen Wertes der Ausgangsgröße zu dem eigenen modellspezifischen Wert der Ausgangsgröße erfolgt wobei das bestimmte Modell den aktuellen Zustand des Systems angibt oder definiert oder beschreibt.

Gemäß einer weiteren vorteilhaften Ausgestaltung kann mindestens ein Zustand im realen System ein fehlerfreier Betrieb sein und in einem aktuellen fehlerfreien Betrieb kann das bestimmte Modell ein "gesundes" Modell sein, das mit einer Betriebsbereitschaftsinformation verknüpft sein kann.

Gemäß einer weiteren vorteilhaften Ausgestaltung können die Zustände im realen System eine Anzahl von jeweilige Fehler aufweisende Fehlerzustände sein und in einem aktuellen Fehlerfall kann das bestimmte Modell ein dem jeweiligen Fehler zugeordnetes Fehlermodell sein, das mit mindestens einer Ortsinformation und/oder mindestens einer Information über die Art des Fehlers verknüpft sein kann. Auf diese Weise kann eine lokale Fehlererkennung basierend auf lokalen Messungen ohne die Notwendigkeit einer schnellen Kommunikation ausgeführt werden. Des Weiteren ist eine Fehlerlokalisierung und Klassifizierung mittels des Vergleichens von aufgezeichneten lokalen Messungen mit einem dynamischen Fehler- beziehungsweise Netzmodell ausführbar. Eine technische Realisierung in einem entsprechenden Schutzsystem ist erfindungsgemäß für die lokale Fehlererkennung sowie die Fehlerlokalisierung und Klassifizierung identisch, so dass keine zusätzlichen Spezialgeräte erforderlich sind.

Gemäß einer weiteren vorteilhaften Ausgestaltung können die Ortsinformation die Identifikation einer fehlerbehafteten elektrischen Leitung und/oder der Ort auf einer fehlerbehafteten elektrischen Leitung sein. Vorteilhaft ergibt sich eine schnell wirksame und gleichzeitig selektive Identifikation eines fehlerbehafteten Netzteils ohne Limitierung der Reaktionszeit durch Kommunikation.

Gemäß einer weiteren vorteilhaften Ausgestaltung können die Information über die Art des Fehlers ein Fehlerwiderstandswert und/oder die Angabe eines Leitungs-Erde- oder Leitungs-Leitungs-Fehlers sein. Grundsätzlich können die Verfahren und die technische Realisierung zur groben und exakten Fehlerlokalisierung sowie Klassifizierung beliebig kombiniert werden.

Die Methode beziehungsweise das Verfahren sowie die technische Realisierung beziehungsweise das Schutzsystem sind für grobe und schnelle Fehlerlokalisierung sowie Klassifizierung identisch, so dass keine zusätzlichen Spezialgeräte erforderlich sind. Die erfindungsgemäße Fehlererkennung und Fehlerlokalisierung sind auf beliebige Netz-Topologien von elektrischen Systemen anwendbar.

Gemäß einer weiteren vorteilhaften Ausgestaltung kann das Anwenden der jeweiligen Schätzeinrichtungsbank aktiviert werden, wenn ein aktuell gemessener Wert der Eingangsgröße einen vorgegebenen Schwellwert über- oder unterschreitet.

Die Eingangsgröße ist eine elektrische Spannung und die Ausgangsgröße ist ein elektrischer Strom an der Messstation.

Gemäß einer weiteren vorteilhaften Ausgestaltung kann die jeweilige Schätzeinrichtung als ein Kalman-Filter ausgebildet sein, der den kleinsten quadratischen Unterschied zwischen Fehler-Modellen und Ein- bzw. Ausgangsgrößen berechnet. Alternativ kann der kleinste quadratische Unterschied mittels numerischer Methoden, z.B. über kleinste Quadrate mittels Matrix-Pseudo-Inversion oder linearen Programmierens, berechnet werden.

Vorteilhaft kann die modellbasierte Fehlerlokalisierung und Klassifizierung auf der Grundlage von Estimatoren ausgeführt werden, die beispielsweise Kalman-Filter sein können.

Ein Kalman-Filter ist insbesondere ein nach seinem Entdecker Rudolf E. Kálmán benannter Satz von mathematischen Gleichungen. Vereinfacht gesprochen wird der Kalman-Filter typischerweise zum Entfernen der von den Messgeräten verursachten Störungen verwendet. Dabei muss die mathematische Struktur des zugrundeliegenden dynamischen Systems (Modell) bekannt sein. Gemäß der vorliegenden Erfindung wird der Kalman-Filter hier nicht als zum Filtern von Störungen verwendet, sondern um die Unterschiede/Störungen/Residuen zwischen idealisiertem Modell und realen Messdaten zu berechnen. Die Größe der von den Kalman-Filtern berechneten Unterschiede/Störungen/ Residuen lassen dann Rückschlüsse auf den realen Fehlerfall zu. Der Filter kann als Hardware und/oder Software implementiert sein. Gemäß einer erfindungsgemäßen Vorrichtung ist wesentlich ein Hardwarebestandteil implementiert.

Gemäß einer weiteren vorteilhaften Ausgestaltung können in der jeweiligen Schätzeinrichtungsbank der Messstation Fehlermodelle abgespeichert werden, die mit Fehlern in einer Mehrzahl von elektrischen Leitungen des Systems verknüpft sein können. Entsprechend kann eine Messstation eine bestimmte Anzahl oder eine Mehrzahl von elektrischen Leitungen des Systems überwachen.

Gemäß einer weiteren vorteilhaften Ausgestaltung kann jede Messstation am Ende einer elektrischen Leitung des Systems positioniert sein. Auf diese Weise kann ein einfacher Zugang zum elektrischen System ausführbar sein.

Gemäß einer weiteren vorteilhaften Ausgestaltung kann für jede Messstation das Überwachen wiederholt mit Taktraten im Millisekundenbereich oder Mikrosekundenbereich ausgeführt werden. Auf diese Weise kann eine schnelle Reaktion der Netzschutztechnik bereitgestellt werden, die von enormer Bedeutung ist, um fehlerbedingte Schäden an den Betriebsmitteln, wie es beispielsweise Konverter oder Wandler sind, zu minimieren. Beispielsweise kann eine Messung alle eine Millisekunde bis 100 Millisekunden ausgeführt werden. Grundsätzlich sind Taktraten von wesentlich größer 1 pro eine Sekunde vorteilhaft.

Gemäß einer weiteren vorteilhaften Ausgestaltung kann das Überwachen von einer Mehrzahl von Messstationen ausgeführt werden.

Gemäß einer weiteren vorteilhaften Ausgestaltung können mittels Übertragungsleitungen zusätzlich Messungen jeweils mindestens eines Wertes mindestens einer Eingangsgröße und mindestens eines Wertes mindestens einer Ausgangsgröße von mindestens einer anderen Messstation für das Überwachen verwendet werden.

Beispielsweise können zusätzlich zu schnellen lokalen Messungen ergänzend langsam übertragene Messungen verwendet und kombiniert werden (z.B. über Übertragungseinrichtungen nach IEC 61850).

Gemäß einer weiteren vorteilhaften Ausgestaltung brauchen lediglich jeweils zuletzt empfangene Werte von der mindestens einen anderen Messstation für das Überwachen verwendet werden.

Gemäß einer weiteren vorteilhaften Ausgestaltung kann für alle Messstationen das Messen synchron, insbesondere mittels eines Zeitstempels, ausgeführt werden.

Eine erfindungsgemäße genaue Fehleridentifikation und Fehlerlokalisierung kann auf Basis aufgezeichneter und/oder synchronisierter Messwerte nach dem Fehler derart ausgeführt werden, dass keine zusätzlichen Messgeräte erforderlich sind.

Gemäß einer weiteren vorteilhaften Ausgestaltung braucht das synchrone Messen lediglich für Messstationen ausgeführt werden, die an einer jeweiligen Konverter-Station des Systems positioniert sind.

Gemäß einer weiteren vorteilhaften Ausgestaltung kann eine übergeordnete Steuereinrichtung mit allen Messstationen kommunikativ verbunden sein.

Gemäß einer weiteren vorteilhaften Ausgestaltung kann die übergeordnete Steuereinrichtung mittels der Messstationen gemessene Werte empfangen und diese zu einer jeweiligen anderen Messstation weitersenden.

Gemäß einer weiteren vorteilhaften Ausgestaltung kann die übergeordnete Steuereinrichtung den Messstationen Referenzsignale, insbesondere zum Synchronisieren, zusenden.

Gemäß einer weiteren vorteilhaften Ausgestaltung kann eine jeweilige Messstation an einem eine Schalteranlage aufweisenden Schutzrelais positioniert sein.

Gemäß einer weiteren vorteilhaften Ausgestaltung kann an beiden Enden einer elektrischen Leitung des Systems jeweils ein Schutzrelais positioniert sein.

Gemäß einer weiteren vorteilhaften Ausgestaltung kann im jeweiligen Fehlerfall mittels der Schaltanlagen der beiden Schutzrelais die betroffene elektrische Leitung aus dem System herausgetrennt werden. Auf diese Weise kann vorteilhaft ein jeweiliger Fehler selektiv geklärt werden, um die Auswirkungen auf das gesamte elektrische System auf ein Minimum zu begrenzen. Dies bedeutet, dass nach einem Fehler lediglich das fehlerbehaftete Betriebsmittel, das beispielsweise eine fehlerhafte Leitung sein kann, vom Netz getrennt wird und der nicht betroffene Netzteil jedoch in Betrieb bleibt. Hierbei können beispielsweise neuartige DC-Leistungsschalter verwendet werden.

Gemäß einer weiteren vorteilhaften Ausgestaltung kann die herausgetrennte elektrische Leitung repariert werden.

Die Erfindung wird anhand von Ausführungsbeispielen in Verbindung mit den Figuren näher beschrieben. Es zeigen:
- Figur 1: ein Ausführungsbeispiel eines herkömmlichen Schutzsystems;
- Figur 2: ein Ausführungsbeispiel eines erfindungsgemäßen Verfahrens;
- Figur 3: ein erstes Ausführungsbeispiel eines erfindungsgemäßen Schutzsystems;
- Figur 4: ein zweites Ausführungsbeispiel eines erfindungsgemäßen Schutzsystems.

Figur 2 zeigt ein Ausführungsbeispiel eines erfindungsgemäßen Verfahrens. Das Verfahren dient zum Überwachen eines mindestens eine Messstation aufweisenden elektrischen Systems, insbesondere eines elektrischen Energieübertragungs- oder Energieverteilungssystems, das grundsätzlich Energie sowohl mittels Gleichstrom als auch Wechselstrom verteilen kann. Es können folgende Schritte ausgeführt werden.

Mit einem ersten Schritt S1 erfolgt zum Erzeugen der Modelle des Systems für die mindestens eine Messstation ein Messen von Zuständen im realen System, wobei für jeden Zustand jede Messung der Messstation jeweils mindestens einen Wert mindestens einer Eingangsgröße und mindestens einen Wert mindestens einer Ausgangsgröße misst und für jeden gemessenen Zustand in einem zweiten Schritt S2 ein Erzeugen eines mathematischen Modells ausgeführt wird, wobei jedes Modell jeden Wert der Eingangsgröße einen eigenen modellspezifischen Wert der Ausgangsgröße zuordnen kann. Es erfolgt ein für die jeweilige Messstation mittels Speichereinrichtungen ausgeführtes Abspeichern von einem jeweiligen Zustand des Systems beschreibenden Modellen des Systems in jeweils einer Schätzeinrichtung, die in eine Schätzeinrichtungsbank integriert werden.

Die Modelle können jeweils aus den Messungen in Schritt S1 abgeleitet werden. Alternativ brauchen Modelle nicht zwingend aus Messdaten erzeugt werden. Modelle können ebenso typischerweise mathematisch (beispielsweise mittels "firstprinciples") über Leitungseigenschaften und/oder der ein System beschreibenden Physik erzeugt werden.

Mit einem vierten Schritt S4 erfolgt ein Anwenden der jeweiligen Schätzeinrichtungsbank oder Estimatorenbank mittels Vergleichens von der jeweiligen Messstation gemessenen Werten mit Werten eines jeweiligen Modells. Mit einem fünften Schritt S5 erfolgt eine Bestimmung des Modells mit dem kleinsten Unterschied oder Residuum der aktuell gemessenen Werte zu eigenen modellspezifischen Werten, wobei das bestimmte Modell den aktuellen Zustand des Systems angibt oder beschreibt.

Das Anwenden der jeweiligen Schätzeinrichtungsbank mittels Vergleichens mittels des vierten Schrittes S4 erfolgt mittels Vergleichens eines aktuell gemessenen Wertes der Ausgangsgröße mit dem jeweiligen eigenen modellspezifischen Werte der Ausgangsgröße eines jeweiligen Modells bei einem von der Messstation aktuell gemessenen und in der Schätzeinrichtungsbank abgespeicherten Wert der Eingangsgröße. Das Bestimmen gemäß dem fünften Schritt S5 des Modells mit dem kleinsten Unterschied oder Residuum wird auf der Grundlage des kleinsten Unterschiedes von aktuell gemessenen und vergangenen Werten der Ausgangsgröße mit dem eigenen modellspezifischen Wert der Ausgangsgröße ausgeführt. Da jedem Fehlermodell mindestens eine Ortsinformation und/oder mindestens eine Information über die Art des Fehlers zugeordnet ist, kann auf eine einfache Weise eine lokale Fehlererkennung, eine Fehlerlokalisierung und/oder eine Fehlerklassifizierung ausgeführt werden.

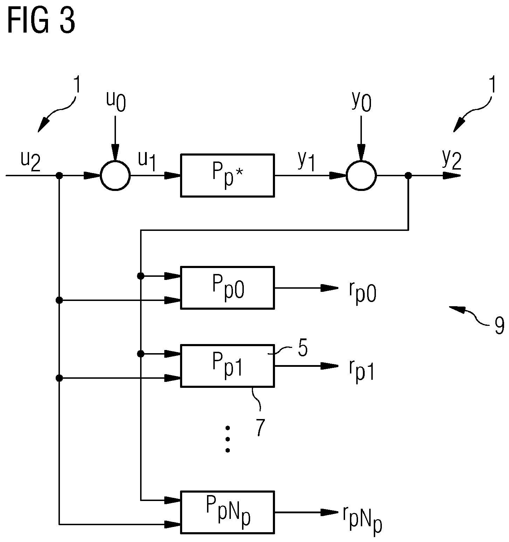

Figur 3 zeigt ein erstes Ausführungsbeispiel eines erfindungsgemäßen Überwachung- und/oder Schutzsystems. Mittels Figur 3 wird eine schnelle grobe Fehlererkennung ohne schnelle Kommunikation beschrieben. Im Gegensatz zu anderen herkömmlichen Schutzmethoden beruht die grobe Fehlererkennung gemäß der vorliegenden Erfindung auf analytischen Modellen des elektrischen Systems 3, das beispielsweise ein elektrisches Netz sein kann. Hierbei wird die Übereinstimmung zwischen dynamischen (Fehler-)Modellen des Netzes und Messdaten evaluiert. Stimmt ein dynamisches Modell mit Messungen im realen Netz gut überein, lassen sich daraus Rückschlüsse auf die fehlerbehaftete Leitung ziehen.

Die Fehlererkennung erfolgt lokal an jeder Netzstation oder Knoten ohne die Notwendigkeit der schnellen Kommunikation zwischen Netzstationen 1. Neben den lokalen schnellen Messungen der Messstation 1 von Strom Y und Spannung U an jeder Messstation 1, können zudem langsame, übertragene Messungen von anderen Messstationen 1 oder Knoten verwendet werden. Da diese im Allgemeinen eine geringere zeitliche Auflösung haben, wird im Fehlerfall nur die letzte zur Verfügung stehende Messung für die schnelle grobe Fehlererkennung genutzt. Die Reaktionszeit der schnellen groben Fehlererkennung wird daher von der Rate der schnellen lokalen Messung sowie der Rechengeschwindigkeit der Recheneinrichtungen beziehungsweise Rechenplattform bestimmt, jedoch nicht von der Übertragungsgeschwindigkeit der Kommunikationseinrichtung, die Messdaten an andere Messstationen 1 oder Knoten übermittelt.

Die Struktur der modellbasierten Fehlererkennung ist in Figur 3 dargestellt. Hierbei wird zunächst eine Anzahl von dynamischen Fehlermodellen Pp1 bis Ppn erstellt, wobei n die Anzahl der Fehlermodelle ist, die das Netz für bestimmte Fehlerfälle beschreiben. Die Fehlerfälle sind beispielsweise durch die fehlerbehaftete Leitung, den Fehlerort, den Fehlertyp und einen Fehlerwiderstand definierbar. Außerdem wird ein den fehlerfreien Betrieb beschreibendes und als "gesund" bezeichenbares Modell Pp0 bereitgestellt. Danach wird jedes Modell Ppi einer sogenannten Schätzeinrichtung 7 oder Estimator zugeordnet, woraus eine Schätzeinrichtungsbank 9 beziehungsweise Estimatorbank resultiert, deren Eingänge die Strom- und Spannungsmessungen Y2 und U2 sind, wie es in Figur 3 dargestellt ist. Die Schätzeinrichtungsbank 9 wird an jedem Schutzobjekt, das beispielsweise ein Ende einer elektrischen Leitung Lk sein kann, angewendet.

Jede Schätzeinrichtung 7 oder Estimator evaluiert die Übereinstimmung zwischen dem dazugehörigen dynamischen Modell und den Messdaten. Dazu berechnet jeder Estimator einen positiven Skalar, das sogenannte Residuum rp0 bis rpn, das einen Indikator für die Übereinstimmung zwischen dem dynamischen Modell und den Messdaten darstellt. Dieses Residuum ist im Allgemeinen klein, wenn das zugehörige Modell die Messung gut beschreibt und groß, wenn die Messung das zugehörige Modell schlecht beschreibt. Das kleinste Residuum verweist auf das Modell Ppi (0<= i <= np) (Im ideal Fall Pp*), das die Messung am besten beschreibt, was wiederum Rückschlüsse auf die fehlerbehaftete Leitung Lk zulässt.

Ein Kalman-Filter stellt eine mögliche Variante der Realisierung eines "Least Squares Estimators" 7 dar. Das heißt, der Kalman-Filter berechnet die kleinste Störung, und zwar in einem quadratischen Sinn, die die Messung Y2 und U2 mit dem jeweiligen Modell Ppi kompatibel machen. Diese kleinste Störung wird Residuum genannt. Der Kalman-Filter wird deshalb ebenso als "Disturbance Estimator" bezeichnet. Andere Varianten von "Disturbance Estimator" als Schätzeinrichtungen 7 sind hierbei beispielsweise numerische Least-Squares-Verfahren über Matrix-Pseudo-Inverse oder über lineares Programmieren. Eine besonders wichtige Eigenschaft der beschriebenen Fehlererkennungsmethode besteht darin, dass im Gegensatz zu anderen Verfahren keine Kalibrierung oder Offline-Simulationen notwendig sind. Außerdem kann das erfindungsgemäße Verfahren beziehungsweise das Schutzsystem auf beliebige Netz-Topologien übertragen werden. Durch das Anwenden von Schätzeinrichtungen 7 ist die Methode zudem robust gegenüber Messrauschen und Änderungen bei Systemparametern. Figur 3 zeigt eine Bank von Schätzeinrichtungen 7 für die Identifikation eines fehlerbehafteten Netzteiles.

Figur 3 beschreibt ebenso eine exakte Fehlerlokalisierung. Ist die fehlerbehaftete Leitung Lk bekannt, kann der exakte Fehlerort bestimmt werden. Die exakte Fehlerlokalisierung funktioniert nach demselben Prinzip wie die Fehlererkennung. Hierbei werden viele Fehlermodelle Ppi erstellt, jeweils für einen bestimmten Fehlerort auf der fehlerbehafteten Leitung Lk. Jedes Modell Ppi wird dann einem Estimator beziehungsweise einer Schätzeinrichtung 7, die beispielsweise mittels eine Kalman-Filters realisiert ist, zugeordnet. Der Estimator mit dem kleinsten Residuum weist auf das Modell, das die Messung am besten beschreibt, was wiederum den exakten Fehlerort identifiziert. Der einzige Unterschied zu der Fehlererkennung liegt bei den verwendeten Strom- und Spannungsmessungen. Hier erfolgt die exakte Fehlerlokalisierung offline, basierend auf historischen, hochaufgelösten und synchronisierten, insbesondere über einen Zeitstempel synchronisierten, Messungen von beiden Leitungsenden der elektrischen Leitung Lk. Es sei hier angemerkt, dass die exakte Fehlerlokalisierung ebenso alleinstehend ausgeführt werden kann, ohne dass vorher die fehlerbehaftete Leitung Lk identifiziert werden muss. In diesem Fall muss die Schätzeinrichtungsbank 9 Fehlermodelle Ppi für mögliche Fehler auf allen Leitungen Lk enthalten. Zudem sind synchrone Messungen von allen Stationen erforderlich.

Figur 3 zeigt ebenso eine Fehlerklassifizierung. Die Klassifizierung des Fehlers ist zum Zeitpunkt der Fehlererkennung oder der exakten Fehlerlokalisierung möglich. Hierbei müssen für verschiedene Fehlertypen, beispielsweise Leitung-Erde-Fehler oder Leitung-Leitung-Fehler, verschiedene Fehlermodelle Ppi in der Estimatorbank oder Schätzeinrichtungsbank 9 verwendet werden. Die Ausführung ist dann analog der exakten Fehlerlokalisierung.

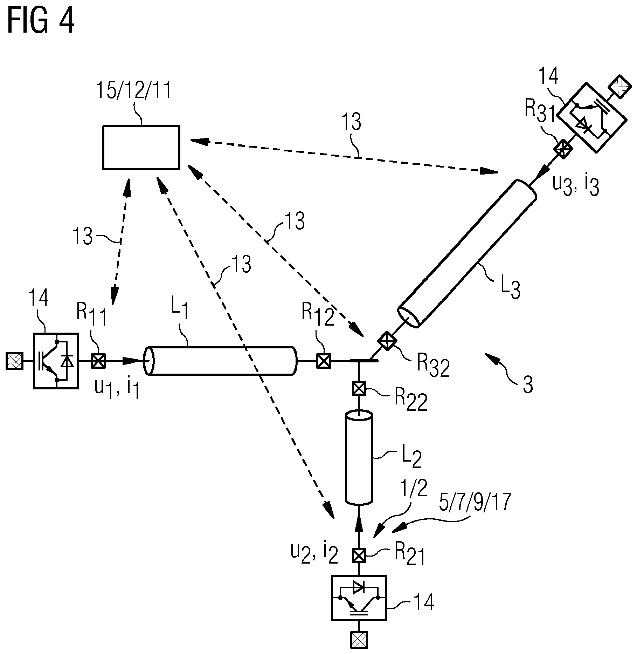

Figur 4 zeigt ein zweites Ausführungsbeispiel eines erfindungsgemäßen Schutzsystems. Es soll ein elektrisches System 3 geschützt werden, das hier beispielsweise ein Hochspannungs-Gleichstromübertragungsnetz ist. Bezugszeichen 1 kennzeichnet jeweilige Messstationen, die zugehörige Rechnereinrichtungen 2, Speichereinrichtungen 5, Schätzeinrichtungen 7 und Schätzeinrichtungsbänke 9 aufweisen. Jede Messstation 1 ist hier einem Schutzrelais Rgh zugeordnet, die jeweils mit einer Schaltanlage 17 fehlerbehaftete elektrische Leitungen Lk aus dem Netz heraustrennen können. Figur 4 zeigt zusätzlich eine übergeordnete Steuereinrichtung 15 mittels jeweiliger Übertragungsleitungen 13 in Kommunikation mit jeweiligen Messstationen 1 und Schaltanlagen 17. Die übergeordnete Steuereinrichtung 15 kann eine Takteinrichtung 12 zum synchronen Takten der Messstationen 1 aufweisen. Zusätzlich kann die übergeordnete Steuereinrichtung 15 eine Anzeigeeinrichtung 11 aufweisen, die Informationen hinsichtlich des Zustandes des elektrischen Systems 3 beispielsweise für eine Betriebsperson anzeigen kann. Grundsätzlich können die Messstationen 1 alternativ oder kumulativ mittels dezentraler Übertragungsleitungen oder mittels Funkübertragung miteinander kommunizieren. Besonders vorteilhaft kann eine jeweilige Messstation 1 einer Konverter-Station oder Wandler-Station 14 zugeordnet sein, die Spannungsebenen und Stromformen anpassen kann. Mit Yi und Ui sind jeweils an einer Messstation 1 gemessene Eingangsgrößen und Ausgangsgrößen. Das in Figur 4 dargestellte Schutzsystem ermöglicht eine Identifikation und Lokalisierung von Leitungsfehlern in Multiterminal-HGÜ-Netzen, auf der Grundlage eines erfindungsgemäßen modellbasierten Schutzsystems für elektrische Systeme, insbesondere elektrische Energiesysteme. Figur 4 stellt beispielsweise ein 3-Terminal-HGÜ-Netz mit drei Konverter-Stationen 14 dar. Die Konverter-Stationen 14 sind mittels drei Kabeln L₁, L₂, L₃ zu einem gemeinsamen Punkt, das heißt zu einer Switching-Station oder Schaltstation verbunden. Jedes Kabel Lk verfügt über zwei Schutzrelais Rgh an beiden Enden. So verfügt beispielsweise das Kabel L₁ über die zwei Schutzrelais R₁₁ und R₁₂. Jedes Schutzrelais Rgh besteht aus einer Strom- und Spannungsmessung sowie einer Schaltanlage 17, die beispielsweise ein DC-Leistungsschalter sein kann, für das Heraustrennen der Leitung Lk im Fehlerfall aus dem System.

Mit dem vorgeschlagenen Schutzsystem können grundsätzlich drei Aufgaben gelöst werden, und zwar die Identifikation der fehlerbehafteten Leitung Lk, die Klassifizierung des Fehlers, der beispielsweise ein Leitung-Leitung-Fehler oder ein Leitung-Erde-Fehler sein kann, sowie die exakte Lokalisierung des Fehlers auf der Leitung Lk.

Es werden mehrere Modelle Ppi für verschiedene Fehlertypen und Fehlerpositionen erstellt und jeweils mit dem gesunden Modell Pp0 einem Estimator oder einer Schätzeinrichtung 7, die beispielsweise ein Kalman-Filter sein kann, zugeordnet. Die daraus resultierende Kalman-Filter-Bank wird dann an jedem Schutzrelais Rgh verwendet oder ausgeführt. Die Kalman-Filter-Bank verwendet schnelle lokale Messungen der Messstation 1 vom dazugehörigen Schutzrelais Rgh sowie die letzten zur Verfügung stehenden Fernmessungen von anderen Messstationen 1 in anderen Schutzrelais Rgh, und zwar vorteilhaft über eine übergeordnete Steuereinrichtung 15. Diese übergeordnete Steuereinrichtung 15 ist kommunikationstechnisch mit allen Messstationen 1 verbunden und nimmt beispielsweise die Messwerte aller Messstationen 1 auf und verteilt diese. Ebenso kann die übergeordnete Steuereinrichtung 15 Messstationen 1 mit bestimmten Referenzsignalen versorgen. Die Kalman-Filter-Bank im Schutzrelais R₁₁ verwendet beispielsweise die schnellen lokalen Messungen U1 und Y1 beziehungsweise I1 sowie langsame Messungen U2, I2, U3 und I3, die beispielsweise über die übergeordnete Steuereinrichtung 15 oder auch dezentral übertragen werden können. Die Kalman-Filter-Bank wird dann ausgeführt, wenn eine Unterspannung im Relais R₁₁ detektiert wird. Die Kalman-Filter-Bank berechnet dann nach dem Fehlerfall Residuen für jedes Fehlermodell Pp0 bis Ppn. Der Kalman-Filter mit dem kleinsten Residuum verweist auf das Modell, das die Messdaten am besten beschreibt. Daraus kann die fehlerbehaftete Leitung Lk identifiziert werden. Auf die gleiche Weise lässt sich die fehlerbehaftete Leitung Lk aus Sicht von Relais R₁₂, R₂₁, R₂₂, R₃₁ und R₃₂ erkennen. Nachdem die fehlerbehaftete Leitung Lk identifiziert wurde, wird ein Auslösesignal an den jeweiligen DC-Leistungsschalter beziehungsweise an die jeweilige Schaltanlage 17 gesendet, damit die Leitung Lk aus dem Netz herausgetrennt wird.

Aus den historisch gespeicherten synchronen Messungen der Messstationen 1 kann die exakte Position des Fehlers auf der fehlerbehafteten Leitung Lk lokalisiert werden. Konkret wird angenommen, dass die Leitung L1 fehlerbehaftet ist. Um die exakte Fehlerposition auf L1 zu bestimmen, müssen synchrone Messungen vom Relais R₁₁ und R₁₂ vorhanden sein. Diese dienen dann als Eingang für eine Schätzeinrichtungsbank 9 beziehungsweise Estimatorbank, bestehend aus verschiedenen Fehlermodellen Ppi für verschiedene Fehlerpositionen auf L1. Der Estimator mit dem kleinsten Residuum verweist auf das Modell Ppi (0<= i <= np) (Im ideal Fall Pp*), das die Messdaten am besten beschreibt. Daraus erschließt sich die exakte Fehlerposition. Als Alternative kann die exakte Fehlerposition auf L1 durch Verwendung von synchronen Messungen von allen Konverter-Stationen 14 bestimmt werden. Hierzu müssen jedoch nicht nur Fehlermodelle für L1, sondern für alle Leitungen Lk erstellt werden und zusammen in der Estimator-Bank beziehungsweise in der Schätzeinrichtungsbank 9 verwendet werden. Dadurch kann die exakte Fehlerlokalisierung unabhängig von der Fehlererkennung durchgeführt werden. Abschließend können die Reparaturarbeiten durchgeführt werden, so dass anschließend die fehlerbehaftete Leitung Lk wieder in Betrieb gesetzt werden kann.

### Literaturliste:

[1] J. Deseloux, P. Rault, S. Nguefeu, J.B. Curis, X. Guillaud, F. Colas and B. Raison, "HVDC meshed grid: Control and protection of a Multi-Terminal HVDC system", CIGRE Session Paris, Paper B4-308, August 2012.
[2] L. Tang, B.-T. Ooi, "Locating and Isolating DC Faults in Multi-Terminal DC Systems," Power Delivery, IEEE Transactions, Vol. 22, No. 3, pp. 1877-1884, July 2007.
[3] K. De Kerf, K. Srivastava, M. Reza, D. Bekaert, S. Cole, D. van Hertem and R. Belmans, "Wavelet-based Protection Strategy for DC Faults in Multi-Terminal VSC HVDC Systems", IET Generation, Transmission & Distribution, Vol. 5, p. 496-503, 04/2011.
[4] US 13/703,930
[5] Buchstaller, Dominic, "Robust Stability and Performance for Multiple Model Switched Adaptive Control", Diss. University of Southampton, 2010

## Patentansprüche

1. Verfahren zum Überwachen eines mindestens eine Messstation (1) aufweisenden elektrischen Systems (3), insbesondere eines elektrischen Energieübertragungssystems, insbesondere eines Hochspannungs-Gleichstrom-Übertragungssystems, mit folgenden Schritten:
- für jeden Zustand des Systems wird ein Erzeugen (S2) eines mathematischen Modells (Ppi) ausgeführt, wobei jedes Modell (Ppi) jedem Wert mindestens einer Eingangsgröße einen eigenen modellspezifischen Wert mindestens einer Ausgangsgröße zuordnet, wobei die Eingangsgröße eine elektrische Spannung (U) und die Ausgangsgröße ein elektrischer Strom (Y) an der jeweiligen Messstation (1) sind,
- für die jeweilige Messstation mittels Speichereinrichtungen (5) ausgeführtes Abspeichern (S3) von den einen jeweiligen Zustand des Systems (3) beschreibenden Modellen (Ppi) des Systems (3) in jeweils einer Schätzeinrichtung (7), wobei diese Schätzeinrichtungen (7) in einer Schätzeinrichtungsbank (9) integriert sind;
- Anwenden der jeweiligen Schätzeinrichtungsbank (9) mittels Vergleichens (S4) von von der jeweiligen Messstation (1) gemessenen Werten mit Werten der jeweiligen erzeugten mathematischen Modelle (Ppi);
- Bestimmen (S5) des Modells (Pp*) mit dem kleinsten Unterschied zwischen den gemessenen Werten und den Werten des jeweiligen Modells (Ppi), wobei das bestimmte Modell (Pp*) den aktuellen Zustand des Systems (3) angibt.

2. Verfahren nach Anspruch 1,
**dadurch gekennzeichnet, dass** zum Erzeugen (S2) der Modelle des Systems (3) für die mindestens eine Messstation (1) mathematische Beschreibungen von physikalischen Eigenschaften des Systems (3), insbesondere von Leitungseigenschaften, verwendet werden.

3. Verfahren nach Anspruch 1 oder 2,
**dadurch gekennzeichnet, dass** mittels der mindestens einen Messstation (1) ein Messen (S1) im realen System ausgeführt wird, wobei für jeden Zustand jede Messung jeweils mindestens einen Wert der mindestens einen Eingangsgröße und mindestens einen Wert der mindestens einen Ausgangsgröße misst.

4. Verfahren nach einem der vorhergehenden Ansprüche,
**dadurch gekennzeichnet, dass** das Anwenden der jeweiligen Schätzeinrichtungsbank mittels Vergleichens (S4) eines aktuell gemessenen Wertes der Ausgangsgröße mit dem jeweiligen eigenen modellspezifischen Wert der Ausgangsgröße eines jeweiligen Modells (Ppi) bei einem von der jeweiligen Messstation (1) aktuell gemessenen und in der Schätzeinrichtungsbank abgespeicherten Wert der Eingangsgröße durchgeführt wird; - Bestimmen (S5) des Modells mit dem kleinsten Unterschied des aktuell gemessenen Wertes der Ausgangsgröße zu dem eigenen modellspezifischen Wert der Ausgangsgröße.

5. Verfahren nach einem der vorhergehenden Ansprüche,
**dadurch gekennzeichnet, dass** mindestens ein Zustand im System ein fehlerfreier Betrieb ist und in einem aktuellen fehlerfreien Betrieb das bestimmte Modell ein den fehlerfeien Betrieb beschreibendes Modell (Pₚ₀) ist, das mit einer an eine Bedienperson ausgebbare Betriebsbereitschaftsinformation verknüpft ist.

6. Verfahren nach einem der vorhergehenden Ansprüche,
**dadurch gekennzeichnet, dass** die Zustände im System eine Anzahl an jeweilige Fehler aufweisende Fehlerzustände sind und in einem aktuellen Fehlerfall das bestimmte Modell ein dem jeweiligen Fehler zugeordnetes Fehlermodell (Pₚ₁...Pₚₙ) ist, das mit mindestens einer Ortsinformation und/oder mindestens einer Information über die Art des Fehlers verknüpft ist.

7. Verfahren nach Anspruch 6,
**dadurch gekennzeichnet, dass** die Ortsinformation die Identifikation und/oder der Ort auf einer fehlerbehafteten elektrischen Leitung (Lk) sind/ist.

8. Verfahren nach Anspruch 6 oder 7,
**dadurch gekennzeichnet, dass** die Information über die Art des Fehlers ein Fehlerwiderstandswert und/oder die Angabe eines Leitungs-Erde- oder Leitungs-Leitungs-Fehlers ist.

9. Verfahren nach einem der vorhergehenden Ansprüche 3 bis 8, **dadurch gekennzeichnet, dass** das Anwenden der jeweiligen Schätzeinrichtungsbank (9) aktiviert wird, wenn ein aktuell gemessener Wert der Eingangsgröße einen vorgegebenen Schwellwert über- oder unterschreitet.

10. Verfahren nach einem der vorhergehenden Ansprüche,
**dadurch gekennzeichnet, dass** die jeweilige Schätzeinrichtung (7) als ein Kalman-Filter ausgebildet ist.

11. Verfahren nach einem der vorhergehenden Ansprüche,
**dadurch gekennzeichnet, dass** in der jeweiligen Schätzeinrichtungsbank (9) der jeweiligen Messstation (1) Fehlermodelle (P_{p1...}Pₚₙ) abspeichert sind, die mit Fehlern in einer bestimmten Anzahl von elektrischen Leitungen (Lk) des Systems (3) verknüpft sind.

12. Verfahren nach einem der vorhergehenden Ansprüche,
**dadurch gekennzeichnet, dass** jede Messstation (1) am Ende einer elektrischen Leitung (Lk) des Systems (3) positioniert ist.

13. Verfahren nach einem der vorhergehenden Ansprüche,
**dadurch gekennzeichnet, dass** für jede Messstation (1) das Überwachen wiederholt mit Taktraten im Millisekundenbereich oder Mikrosekundenbereich ausgeführt wird.

14. Verfahren nach einem der vorhergehenden Ansprüche,
**dadurch gekennzeichnet, dass** das Überwachen von einer Mehrzahl von Messstationen (1) ausgeführt wird.

15. Verfahren nach Anspruch 14,
**dadurch gekennzeichnet, dass** mittels Kommunikationseinrichtungen, insbesondere Übertragungsleitungen (13), zusätzlich Messungen jeweils mindestens eines Wertes mindestens einer Eingangsgröße und mindestens eines Wertes mindestens einer Ausgangsgröße von mindestens einer anderen Messstation (1) für das Überwachen verwendet werden.

16. Verfahren nach Anspruch 15,
**dadurch gekennzeichnet, dass** jeweils zuletzt empfangene Werte von der mindestens einen anderen Messstation (1) für das Überwachen verwendet werden.

17. Verfahren nach Anspruch 14, 15 oder 16,
**dadurch gekennzeichnet, dass** mittels aller Messstationen (1) das Messen synchron, insbesondere mittels eines Zeitstempels, ausgeführt wird.

18. Verfahren nach Anspruch 17,
**dadurch gekennzeichnet, dass** das synchrone Messen lediglich mittels Messstationen (1) ausgeführt wird, die an einer jeweiligen Konverter-Station (11) des Systems (3) positioniert sind.

19. Verfahren nach einem der vorhergehenden Ansprüche 14 bis 18,
**dadurch gekennzeichnet, dass** eine übergeordnete Steuereinrichtung (15) mit allen Messstationen (1) kommunikativ verbunden ist.

20. Verfahren nach Anspruch 19,
**dadurch gekennzeichnet, dass** die übergeordnete Steuereinrichtung (15) mittels den Messstationen (1) gemessene Werte empfängt und diese zu einer jeweiligen anderen Messstationen (1) weitersendet.

21. Verfahren nach Anspruch 19 oder 20,
**dadurch gekennzeichnet, dass** die übergeordnete Steuereinrichtung (15) den Messstationen (1) Referenzsignale, insbesondere zum Synchronisieren, zusendet.

22. Verfahren nach einem der Ansprüche 14 bis 21,
**dadurch gekennzeichnet, dass** eine jeweilige Messstation (1) an einem eine Schaltanlage (17) aufweisenden Schutzrelais (Rgh) positioniert ist.

23. Verfahren nach Anspruch 22,
**dadurch gekennzeichnet, dass** an beiden Enden einer elektrischen Leitung (Lk) des Systems (3) jeweils ein Schutzrelais (Rgh) positioniert ist.

24. Verfahren nach Anspruch 23,
**dadurch gekennzeichnet, dass** in einem jeweiligen Fehlerfall mittels der Schaltanlagen (17) der beiden Schutzrelais (Rgh) die betroffene elektrische Leitung (Lk) aus dem System (3) herausgetrennt wird.

25. Verfahren nach Anspruch 24,
**dadurch gekennzeichnet, dass** die herausgetrennte elektrische Leitung (Lk) repariert wird.

26. Schutzsystem zur Überwachung eines mindestens eine Messstation (1) aufweisenden elektrischen Systems (3), insbesondere eines elektrischen Energieübertragungssystems, insbesondere eines Hochspannungs-Gleichstrom-Übertragungssystems, aufweisend
- eine Rechnereinrichtung (2), die dazu eingerichtet ist, für jeden Zustand des Systems ein mathematisches Modell (Ppi) zu erzeugen, wobei jedes Modell (Ppi) jedem Wert mindestens einer Eingangsgröße einen eigenen modellspezifischen Wert mindestens einer Ausgangsgröße zuordnet, wobei die Eingangsgröße eine elektrische Spannung (U) und die Ausgangsgröße ein elektrischer Strom (Y) an der jeweiligen Messstation (1) sind,
- für die jeweilige Messstation (1) geschaffene Speichereinrichtungen (5) eingerichtet zum Abspeichern (S3) von den einen jeweiligen Zustand des Systems (3) beschreibenden Modellen (Ppi) des Systems (3) in jeweils einer Schätzeinrichtung (7), die in einer Schätzeinrichtungsbank (9) integriert sind, die die dazu eingerichtet sind, die von der jeweiligen Messstation (1) gemessenen Werte mit Werten des jeweiligen Modells (Ppi) zu vergleichen und das Modell (Pp*) mit dem kleinsten Unterschied zwischen den gemessenen Werten und den Werten des jeweiligen Modells (Ppi) zu bestimmen, wobei das bestimmte Modell (Pp*) den aktuellen Zustand des Systems (3) angibt.

27. Schutzsystem nach Anspruch 26,
**dadurch gekennzeichnet, dass** die mindestens eine Messstation (1) zum Messen im System geschaffen ist, und wobei das Schutzsystem dazu eingerichtet ist, dass für jeden Zustand jede Messstation (1) jeweils mindestens einen Wert der mindestens einen Eingangsgröße und mindestens einen Wert der mindestens einen Ausgangsgröße erfasst.

28. Schutzsystem nach einem der vorhergehenden Ansprüche 26 bis 27,
**dadurch gekennzeichnet, dass** die Schätzeinrichtungsbank (9) derart eingerichtet ist, einen aktuell gemessenen Wert der Ausgangsgröße mit dem jeweiligen eigenen modellspezifischen Wert der Ausgangsgröße eines jeweiligen Modells (Ppi) bei einem von der Messstation (1) aktuell gemessenen und in der Schätzeinrichtungsbank (9) abgespeicherten Wert der Eingangsgröße zu vergleichen und das Modell mit dem kleinsten Unterschied des aktuell gemessenen Wertes der Ausgangsgröße zu dem eigenen modellspezifischen Wert der Ausgangsgröße zu bestimmen, wobei das bestimmte Modell den Zustand des Systems angibt.

29. Schutzsystem nach einem der vorhergehenden Ansprüche 26 bis 28,
**dadurch gekennzeichnet, dass** mindestens ein Zustand im System ein fehlerfreier Betrieb ist und in einem aktuellen fehlerfreien Betrieb das bestimmte Modell ein gesundes Modell (Pₚ₀) ist, das mit einer Betriebsbereitschaftsinformation verknüpft ist, die mittels einer Anzeigeeinrichtung (11) darstellbar ist.

30. Schutzsystem nach einem der vorhergehenden Ansprüche 26 bis 29,
**dadurch gekennzeichnet, dass** die Zustände im System eine Anzahl an jeweilige Fehler aufweisende Fehlerzustände sind und in einem aktuellen Fehlerfall das bestimmte Modell ein dem jeweiligen Fehler zugeordnetes Fehlermodell (Pₚ₁...Pₚₙ) ist, das mit mindestens einer Ortsinformation und/oder mindestens einer Information über die Art des Fehlers verknüpft ist, die mittels einer Anzeigeeinrichtung (11) darstellbar sind/ist.

31. Schutzsystem nach einem der vorhergehenden Ansprüche 27 bis 30,
**dadurch gekennzeichnet, dass** die jeweilige Schätzeinrichtungsbank (9) derart eingerichtet ist, aktiv zu werden, wenn ein aktuell gemessener Wert der Eingangsgröße einen vorgegebenen Schwellwert über- oder unterschreitet.

32. Schutzsystem nach einem der vorhergehenden Ansprüche 26 bis 31,
**dadurch gekennzeichnet, dass** die jeweilige Schätzeinrichtung (7) als ein Kalman-Filter ausgebildet ist.

33. Schutzsystem nach einem der vorhergehenden Ansprüche 26 bis 32,
**dadurch gekennzeichnet, dass** jede Messstation (1) am Ende einer elektrischen Leitung (Lk) des Systems (3), insbesondere an einer jeweiligen Konverter-Station (14) des Systems (3) positioniert ist.

34. Schutzsystem nach einem der vorhergehenden Ansprüche 26 bis 33,
**dadurch gekennzeichnet, dass** für jede Messstation (1) die Überwachung mittels einer Takteinrichtung (12) wiederholt mit Taktraten im Millisekundenbereich oder Mikrosekundenbereich ausgeführt wird.

35. Schutzsystem nach einem der vorhergehenden Ansprüche 26 bis 34,
**dadurch gekennzeichnet, dass** die Überwachung von einer Mehrzahl von Messstationen (1) ausgeführt wird.

36. Schutzsystem nach Anspruch 35,
**dadurch gekennzeichnet, dass** mittels Kommunikationseinrichtungen, insbesondere Übertragungsleitungen (13), zusätzlich Messungen jeweils mindestens eines Wertes mindestens einer Eingangsgröße und mindestens eines Wert mindestens einer Ausgangsgröße von mindestens einer anderen Messstation (1) für die Überwachung verwendet werden.

37. Schutzsystem nach einem der vorhergehenden Ansprüche 35 bis 36,
**dadurch gekennzeichnet, dass** eine übergeordnete Steuereinrichtung (15) mit allen Messstationen (1) kommunikativ verbunden ist.

38. Schutzsystem nach einem der Ansprüche 35 bis 37,
**dadurch gekennzeichnet, dass** eine jeweilige Messstation (1) an einem eine Schaltanlage (17) aufweisenden Schutzrelais (Rgh) positioniert ist.

39. Schutzsystem nach Anspruch 38,
**dadurch gekennzeichnet, dass** an beiden Enden einer elektrischen Leitung (Lk) des Systems (3) jeweils ein Schutzrelais (Rgh) positioniert ist und im jeweiligen Fehlerfall mittels Schaltanlagen (17) der beiden Schutzrelais (Rgh) die betroffene elektrische Leitung (Lk) aus dem System (3) heraus trennbar und reparierbar ist.

## Claims

1. Method for monitoring an electrical system (3) having at least one measuring station (1), in particular an electrical energy transmission system, in particular a high-voltage DC transmission system, having the following steps:
- a mathematical model (Ppi) is produced (S2) for each state of the system, wherein each model (Ppi) assigns a dedicated model-specific value of at least one output variable to each value of at least one input variable, wherein the input variable is a voltage (U) and the output variable is an electric current (Y) at the respective measuring station (1),
- for the respective measuring station, storing (S3), carried out by means of storage devices (5), the models (Ppi) of the system (3) that describe a respective state of the system (3) in a respective estimation device (7), wherein these estimation devices (7) are integrated in a bank of estimation devices (9);
- using the respective bank of estimation devices (9) by comparing (S4) values measured by the respective measuring station (1) with values of the respective produced mathematical models (Ppi);
- determining (S5) the model (Pp*) with the smallest difference between the measured values and the values of the respective model (Ppi), wherein the determined model (Pp*) indicates the current state of the system (3).

2. Method according to Claim 1,
**characterized in that** mathematical descriptions of physical properties of the system (3), in particular line properties, are used to produce (S2) the models of the system (3) for the at least one measuring station (1).

3. Method according to Claim 1 or 2,
**characterized in that** measurement (S1) is carried out in the real system by means of the at least one measuring station (1), wherein, for each state, each measurement in each case measures at least one value of the at least one input variable and at least one value of the at least one output variable.

4. Method according to one of the preceding claims, **characterized in that** the respective bank of estimation devices is used by comparing (S4) a currently measured value of the output variable with the respective dedicated model-specific value of the output variable of a respective model (Ppi) in the case of a value of the input variable that is currently measured by the respective measuring station (1) and stored in the bank of estimation devices;
- determining (S5) the model with the smallest difference between the currently measured value of the output variable and the dedicated model-specific value of the output variable.

5. Method according to one of the preceding claims,
**characterized in that** at least one state in the system is a fault-free mode and, in a current fault-free mode, the determined model is a model (Pₚ₀) that describes the fault-free mode and is linked to an item of information concerning operational readiness that can be output to an operator.

6. Method according to one of the preceding claims,
**characterized in that** the states in the system are a number of fault states having respective faults and, in a current fault case, the determined model is a fault model (P_{p1...}Pₚₙ) that is assigned to the respective fault and is linked to at least one item of location information and/or at least one item of information relating to the type of the fault.

7. Method according to Claim 6,
**characterized in that** the item of location information is the identification and/or the location on a faulty electrical line (Lk) .

8. Method according to Claim 6 or 7,
**characterized in that** the item of information relating to the type of the fault is a fault resistance value and/or the indication of a line-to-earth fault or a line-to-line fault.

9. Method according to one of the preceding Claims 3 to 8, **characterized in that** use of the respective bank of estimation devices (9) is activated when a currently measured value of the input variable exceeds or falls below a predefined threshold value.

10. Method according to one of the preceding claims,
**characterized in that** the respective estimation device (7) is in the form of a Kalman filter.

11. Method according to one of the preceding claims,
**characterized in that** fault models (P_{p1...}Pₚₙ) that are linked to faults in a certain number of electrical lines (Lk) of the system (3) are stored in the respective bank of estimation devices (9) of the respective measuring station (1).

12. Method according to one of the preceding claims,
**characterized in that** each measuring station (1) is positioned at the end of an electrical line (Lk) of the system (3).

13. Method according to one of the preceding claims,
**characterized in that**, for each measuring station (1), monitoring is carried out repeatedly with clock rates in the millisecond range or microsecond range.

14. Method according to one of the preceding claims,
**characterized in that** monitoring is carried out by a plurality of measuring stations (1).

15. Method according to Claim 14,
**characterized in that** measurements in each case of at least one value of at least one input variable and of at least one value of at least one output variable are additionally used for monitoring by at least one other measuring station (1) by means of communication devices, in particular transmission lines (13) .

16. Method according to Claim 15,
**characterized in that** respectively last received values are used for monitoring by the at least one other measuring station (1) .

17. Method according to Claim 14, 15 or 16,
**characterized in that** measurement is carried out synchronously, in particular by means of a time stamp, by means of all the measuring stations (1).

18. Method according to Claim 17,
**characterized in that** synchronous measurement is carried out only by means of measuring stations (1) that are positioned at a respective converter station (11) of the system (3).

19. Method according to one of the preceding Claims 14 to 18, **characterized in that** a superordinate control device (15) is communicatively connected to all the measuring stations (1).

20. Method according to Claim 19,
**characterized in that** the superordinate control device (15) receives values measured by means of the measuring stations (1) and forwards said values to a respective other measuring station (1).

21. Method according to Claim 19 or 20,
**characterized in that** the superordinate control device (15) sends reference signals, in particular for synchronization, to the measuring stations (1).

22. Method according to one of Claims 14 to 21,
**characterized in that** a respective measuring station (1) is positioned on a protective relay (Rgh) having switchgear (17).

23. Method according to Claim 22,
**characterized in that** a respective protective relay (Rgh) is positioned at both ends of an electrical line (Lk) of the system (3).

24. Method according to Claim 23,
**characterized in that**, in a respective fault case, the affected electrical line (Lk) is removed from the system (3) by means of the switchgear (17) of the two protective relays (Rgh).

25. Method according to Claim 24,
**characterized in that** the removed electrical line (Lk) is repaired.

26. Protective system for monitoring an electrical system (3) having at least one measuring station (1), in particular an electrical energy transmission system, in particular a high-voltage DC transmission system, having:
- a computer device (2) that is configured to produce a mathematical model (Ppi) for each state of the system, wherein each model (Ppi) assigns a dedicated model-specific value of at least one output variable to each value of at least one input variable, wherein the input variable is a voltage (U) and the output variable is an electric current (Y) at the respective measuring station (1),
- storage devices (5) created for the respective measuring station (1) and configured to store (S3) the models (Ppi) of the system (3) that describe a respective state of the system (3) in a respective estimation device (7) integrated in a bank of estimation devices (9) configured to compare the values measured by the respective measuring station (1) with values of the respective model (Ppi), and to determine the model (Pp*) with the smallest difference between the measured values and the values of the respective model (Ppi), wherein the determined model (Pp*) indicates the current state of the system (3).

27. Protective system according to Claim 26,
**characterized in that** the at least one measuring station (1) is created for measurement in the system, and wherein the protective system is configured such that, for each state, each measuring station (1) detects in each case at least one value of the at least one input variable and at least one value of the at least one output variable.

28. Protective system according to either of the preceding Claims 26 and 27,
**characterized in that** the bank of estimation devices (9) is configured to compare a currently measured value of the output variable with the respective dedicated model-specific value of the output variable of a respective model (Ppi) in the case of a value of the input variable that is currently measured by the measuring station (1) and stored in the bank of estimation devices (9), and to determine the model with the smallest difference between the currently measured value of the output variable and the dedicated model-specific value of the output variable, wherein the determined model indicates the state of the system.

29. Protective system according to one of the preceding Claims 26 to 28,
**characterized in that** at least one state in the system is a fault-free mode and, in a current fault-free mode, the determined model is a healthy model (Pₚ₀) that is linked to an item of information concerning operational readiness that can be displayed by means of a display device (11).

30. Protective system according to one of the preceding Claims 26 to 29,
**characterized in that** the states in the system are a number of fault states having respective faults and, in a current fault case, the determined model is a fault model (P_{p1...}Pₚₙ) that is assigned to the respective fault and is linked to at least one item of location information and/or at least one item of information relating to the type of the fault that can be displayed by means of a display device (11).

31. Protective system according to one of the preceding Claims 27 to 30,
**characterized in that** the respective bank of estimation devices (9) is configured to become active when a currently measured value of the input variable exceeds or falls below a predefined threshold value.

32. Protective system according to one of the preceding Claims 26 to 31,
**characterized in that** the respective estimation device (7) is in the form of a Kalman filter.

33. Protective system according to one of the preceding Claims 26 to 32,
**characterized in that** each measuring station (1) is positioned at the end of an electrical line (Lk) of the system (3), in particular at a respective converter station (14) of the system (3) .

34. Protective system according to one of the preceding Claims 26 to 33,
**characterized in that**, for each measuring station (1), monitoring is carried out repeatedly by means of a clock device (12) with clock rates in the millisecond range or microsecond range.

35. Protective system according to one of the preceding Claims 26 to 34,
**characterized in that** monitoring is carried out by a plurality of measuring stations (1).

36. Protective system according to Claim 35,
**characterized in that** measurements in each case of at least one value of at least one input variable and of at least one value of at least one output variable are additionally used for monitoring by at least one other measuring station (1) by means of communication devices, in particular transmission lines (13) .

37. Protective system according to either of the preceding Claims 35 and 36,
**characterized in that** a superordinate control device (15) is communicatively connected to all the measuring stations (1).

38. Protective system according to one of Claims 35 to 37, **characterized in that** a respective measuring station (1) is positioned on a protective relay (Rgh) having switchgear (17).

39. Protective system according to Claim 38,
**characterized in that** a respective protective relay (Rgh) is positioned at both ends of an electrical line (Lk) of the system (3) and, in the respective fault case, the affected electrical line (Lk) can be removed from the system (3) by means of switchgear (17) of the two protective relays (Rgh) and repaired.

## Revendications

1. Procédé de contrôle d'un système (3) électrique ayant au moins un poste (1) de mesure, notamment d'un système de transport d'énergie électrique, notamment d'un système de transport de courant continu de haute tension, comprenant les stades suivants :
- pour chaque état du système, on réalise une production (S2) d'un modèle (Ppi) mathématique, dans lequel chaque modèle (Ppi) associe à chaque valeur d'au moins une grandeur d'entrée une valeur propre spécifique au modèle d'au moins une grandeur de sortie, dans lequel la grandeur d'entrée est une tension (U) électrique et la grandeur de sortie est un courant (Y) électrique au poste (1) respectif de mesure,
- pour le poste respectif de mesure, mise en mémoire (S3), réalisée au moyen de dispositifs (5) de mise en mémoire, des modèles (Ppi) du système (3) décrivant un état respectif du système (3) dans respectivement un dispositif (7) d'estimation, dans lequel ces dispositifs (7) d'estimation sont intégrés dans une base (9) de dispositif d'estimation ;
- application de la base (9) respective de dispositif d'estimation au moyen d'une comparaison (S4) de valeurs, mesurées par le poste (1) respectif de mesure, à des valeurs des modèles (Ppi) mathématiques respectifs produits ;
- détermination (S5) du modèle (Pp*) ayant la différence la plus petite entre les valeurs mesurées et les valeurs du modèle (Ppi) respectif, le modèle (Pp*) déterminé indiquant l'état en cours du système (3).

2. Procédé suivant la revendication 1, **caractérisé en ce que**, pour la production (S2) des modèles du système (3), pour le au moins un poste (1) de mesure, on utilise des descriptions mathématiques de propriétés physiques du système (3), notamment des propriétés de conduction.

3. Procédé suivant la revendication 1 ou 2,
**caractérisé en ce que**, au moyen du au moins un poste (1) de mesure, on effectue une mesure (S1) dans le système réel, dans lequel, pour chaque état, chaque mesure mesure respectivement au moins une valeur de la au moins une grandeur d'entrée et au moins une valeur de la au moins une grandeur de sortie.

4. Procédé suivant l'une des revendications précédentes, **caractérisé en ce que** l'on effectue l'application de la base respective de dispositif d'estimation au moyen d'une comparaison (S4) d'une valeur en cours de mesure de la grandeur de sortie à la valeur propre spécifique au modèle respective de la grandeur de sortie d'un modèle (Ppi) respectif pour une valeur, en cours de mesure par le poste (1) respectif de mesure et mise en mémoire dans la base de dispositif d'estimation, de la grandeur d'entrée ;
- détermination (S5) du modèle ayant la différence la plus petite de la valeur en cours de mesure de la grandeur de sortie à la valeur propre spécifique au modèle de la grandeur de sortie.

5. Procédé suivant l'une des revendications précédentes, **caractérisé en ce qu'**au moins un état du système est à fonctionnement sans défaut et dans un fonctionnement en cours sans défaut, le modèle déterminé est un modèle (Pₚ₀) décrivant le fonctionnement sans défaut, qui est combiné à une information de disponibilité au fonctionnement pouvant être envoyée à une personne de service.

6. Procédé suivant l'une des revendications précédentes, **caractérisé en ce que** les états du système sont un certain nombre d'états défectueux ayant des défauts respectifs et, dans un cas de défaut en cours, le modèle déterminé est un modèle (P_{p1...}Pₚₙ) de défaut associé au défaut respectif, qui est combiné à au moins une information d'emplacement et/ou à une information sur le type du défaut.

7. Procédé suivant la revendication 6,
**caractérisé en ce que** l'identification et/ou l'emplacement sur une ligne (Lk) électrique entachée de défauts est/sont l'information ou les informations d'emplacement.

8. Procédé suivant la revendication 6 ou 7,
**caractérisé en ce que** l'information sur le type du défaut est une valeur de résistance de défaut et/ou l'indication d'un défaut de ligne-terre ou de ligne-ligne.

9. Procédé suivant l'une des revendications 3 à 8 précédentes, **caractérisé en ce que** l'on active l'application de la base (9) respective de dispositif d'estimation, si une valeur en cours de mesure de la grandeur d'entrée est supérieure ou inférieure à une valeur de seuil donnée à l'avance.

10. Procédé suivant l'une des revendications précédentes, **caractérisé en ce que** le dispositif (7) respectif d'estimation est constitué sous la forme d'un filtre Kalman.

11. Procédé suivant l'une des revendications précédentes, **caractérisé en ce que** dans la base (9) respective de dispositif d'estimation du poste (1) respectif de mesure sont mis en mémoire des modèles (P_{p1...}Pₚₙ) de défaut, qui sont combinés à des défauts dans un nombre déterminé de lignes (Lk) électrique du système (3).

12. Procédé suivant l'une des revendications précédentes, **caractérisé en ce que** chaque poste (1) de mesure est placé au bout d'une ligne (Lk) électrique du système (3).

13. Procédé suivant l'une des revendications précédentes, **caractérisé en ce que** pour chaque poste (1) de mesure, on effectue le contrôle de manière répétée à des cadences d'échantillonnage dans la plage des millisecondes ou dans la plage des microsecondes.

14. Procédé suivant l'une des revendications précédentes, **caractérisé en ce que** l'on effectue le contrôle par une pluralité de postes (1) de mesure.

15. Procédé suivant la revendication 14,
**caractérisé en ce que**, au moyen de dispositifs de communication, notamment de lignes (13) de transmission, on utilise pour le contrôle des mesures supplémentaires respectivement d'au moins une valeur d'au moins une grandeur d'entrée et d'au moins une valeur d'au moins une grandeur de sortie par au moins un autre poste (1) de mesure.

16. Procédé suivant la revendication 15,
**caractérisé en ce que** l'on utilise pour le contrôle respectivement les valeurs reçues en dernier du au moins un autre poste (1) de mesure.

17. Procédé suivant la revendication 14, 15 ou 16,
**caractérisé en ce que** l'on effectue au moyen de tous les postes (1) de mesure la mesure en synchronisme, notamment au moyen d'un horodatage.

18. Procédé suivant la revendication 17,
**caractérisé en ce que** l'on effectue la mesure en synchronisme seulement au moyen des postes (1) de mesure, qui sont placés à un poste (11) respectif de convertisseur du système (3).

19. Procédé suivant l'une des revendications 14 à 18 précédentes, **caractérisé en ce qu'**un dispositif (15) de mesure supérieur hiérarchiquement est relié en communication à tous les postes (1) de mesure.

20. Procédé suivant la revendication 19,
**caractérisé en ce que** le dispositif (15) de commande supérieur hiérarchiquement reçoit des valeurs mesurées au moyen des postes (1) de mesure et les achemine à un autre poste (1) de mesure.

21. Procédé suivant la revendication 19 ou 20,
**caractérisé en ce que** le dispositif (15) de commande supérieur hiérarchiquement envoie, notamment pour la synchronisation, des signaux de référence aux postes (1) de mesure.

22. Procédé suivant l'une des revendications 14 à 21,
**caractérisé en ce qu'**un poste (1) de mesure respectif est placé à un relai (Rgh) de protection ayant une installation (17) de coupure.

23. Procédé suivant la revendication 22,
**caractérisé en ce que** respectivement un relais (Rgh) de protection est placé aux deux bouts d'une ligne (Lk) électrique du système (3).

24. Procédé suivant la revendication 23,
**caractérisé en ce que** dans un cas respectif de défaut, on sépare, au moyen des installations (17) de coupure des deux relais (Rgh) de protection, la ligne (Lk) électrique concernée du système (3).

25. Procédé suivant la revendication 24,
**caractérisé en ce que** l'on répare la ligne (Lk) électrique séparée.

26. Système de protection pour le contrôle d'un système (3) électrique ayant au moins un poste (1) de mesure, notamment d'un système de transport d'énergie électrique, notamment d'un système de transport de courant continu de haute tension, comportant :
- un dispositif (2) informatique, qui est conçu pour produire, pour chaque état du système, un modèle (Ppi) mathématique,
dans lequel chaque modèle (Ppi) associe à chaque valeur d'au moins une grandeur d'entrée une valeur propre spécifique au modèle d'au moins une grandeur de sortie, la grandeur d'entrée étant une tension (U) électrique et la grandeur de sortie un courant (Y) électrique au poste (1) respectif de mesure,
- des dispositifs (5) de mise en mémoire faits pour le poste (1) respectif de mesure pour la mise en mémoire (S3) des modèles (Ppi) du système (3), décrivant un état respectif du système (3), dans respectivement un dispositif (7) d'estimation, qui sont intégrés dans une base (9) de dispositif d'estimation, qui sont conçus pour comparer les valeurs mesurées par le poste (1) respectif de mesure à des valeurs du modèle (Ppi) respectif et pour déterminer le modèle (Pp*) ayant la différence la plus petite entre les valeurs mesurées et les valeurs du modèle (Ppi) respectif, le modèle (Pp*) déterminé indiquant l'état en cours du système (3).

27. Système de protection suivant la revendication 26, **caractérisé en ce que** le au moins un poste (1) de mesure est fait pour la mesure dans le système, et dans lequel le système de protection est conçu pour que, pour chaque état, chaque poste (1) de mesure détecte respectivement au moins une valeur de la au moins une grandeur d'entrée et au moins une valeur de la au moins une grandeur de sortie.

28. Système de protection suivant l'une des revendications 26 à 27 précédentes,
**caractérisé en ce que** la base (9) de dispositif d'estimation est conçue de manière à comparer une valeur en cours de mesure de la grandeur de sortie à la valeur propre spécifique au modèle respectif de la grandeur de sortie d'un modèle (Ppi) respectif pour une valeur de la grandeur d'entrée, en cours de mesure par le poste (1) de mesure et mise en mémoire dans la base (9) de dispositif d'estimation et pour déterminer le modèle ayant la différence la plus petite de la valeur en cours de mesure de la grandeur de sortie à la valeur propre spécifique au modèle de la grandeur de sortie, le modèle déterminé indiquant l'état du système.

29. Système de protection suivant l'une des revendications 26 à 28 précédentes,
**caractérisé en ce que** le au moins un état du système est un fonctionnement sans défaut et dans un fonctionnement en cours sans défaut, le modèle déterminé est un modèle (Pₚ₀) sain, qui est combiné à une information de disponibilité au fonctionnement, qui peut être représentée au moyen d'un dispositif (11) d'affichage.

30. Système de protection suivant l'une des revendications 26 à 29 précédentes,
**caractérisé en ce que** les états du système sont un certain nombre d'états défectueux ayant des défauts respectifs et, dans un cas de défaut en cours, le modèle déterminé est un modèle (P_{p1...}Pₚₙ) de défaut associé au défaut respectif, qui est combiné à au moins une information d'emplacement et/ou à une information sur le type du défaut, qui peuvent/ peut/ veut être représentée (s) au moyen d'un dispositif (11) d'affichage.

31. Système de protection suivant l'une des revendications 27 à 30 précédentes,
**caractérisé en ce que** la base (9) respective de dispositif d'estimation est conçue pour devenir active si une valeur en cours de mesure de la grandeur d'entrée devient supérieure ou inférieure à un seuil donné à l'avance.

32. Système de protection suivant l'une des revendications 26 à 31 précédentes,
**caractérisé en ce que** le dispositif (7) respectif d'estimation est constitué sous la forme d'un filtre de Kalman.

33. Système de protection suivant l'une des revendications 26 à 32 précédentes,
**caractérisé en ce que** chaque poste (1) de mesure est placé au bout d'une ligne (Lk) électrique du système (3), notamment à un poste (14) respectif de convertisseur du système (3).

34. Système de protection suivant l'une des revendications 26 à 33 précédentes,
**caractérisé en ce que** pour chaque poste (1) de mesure, on effectue le contrôle de manière répétée au moyen d'un dispositif (12) d'horloge à des cadences d'échantillonnage dans la plage des millisecondes ou dans la plage des microsecondes.

35. Système de protection suivant l'une des revendications 26 à 34 précédentes,
**caractérisé en ce que** l'on effectue le contrôle par une pluralité de postes (1) de mesure.

36. Système de protection suivant la revendication 35,
**caractérisé en ce que** au moyen de dispositifs de communication, notamment de lignes (13) de transmission, on utilise pour le contrôle des mesures supplémentaires respectivement d'au moins une valeur d'au moins une grandeur d'entrée et d'au moins une valeur d'au moins une grandeur de sortie par au moins un autre poste (1) de mesure.

37. Système de protection suivant l'une des revendications 35 à 36 précédentes,
**caractérisé en ce qu'**un dispositif (15) de commande supérieur hiérarchiquement est relié en communication à tous les postes (1) de mesure.

38. Système de protection suivant l'une des revendications 35 à 37,
**caractérisé en ce qu'**un poste (1) de mesure respectif est placé à un relais (Rgh) de protection ayant une installation (17) de coupure.

39. Système de protection suivant la revendication 38,
**caractérisé en ce que** respectivement un relais (Rgh) de protection est placé aux deux bouts d'une ligne (Lk) électrique du système (3) et, en cas de défaut respectif, au moyen d'installations de coupure des deux relais (Rgh) de protection, la ligne (Lk) électrique concernée peut être séparée du système (3) et peut être réparée.
